# EUROPEAN PATENT APPLICATION

(11) **EP 2 879 475 A1**
(43) Date of publication of application: **03.06.2015**
(21) Application number: 13194545.3
(22) Date of filing: 27.11.2013
(51) Int. Cl.: H05K 7/20

(54) **Solar inverter**

(71) Applicant: SMA Solar Technology AG, 34266 Niestetal (DE)
(72) Inventor: Joergensen, Claus E., 6320 Egernsund (DK); Gram-Hansen, Thomas, 6400 Soenderborg (DK); Hjerrild, Karsten, 6400 Soenderborg (DK); Borup, Finn, 6470 Sydals (DK); Mortensen, Henning Markus, 6780 Skaerbaek (DK); Sengodan Kannaiyan, Rajkumar, 6400 Soenderborg (DK); Andersen, Morten, 24939 Flensburg (DE); Christensen, Brian Beck, 6470 Sydals (DK); Hansen, Carsten R., 6310 Broager (DK); Christensen, Nils Moeller, 6430 Nordborg (DK)
(74) Representative: Lahnor, Peter

(57) **Abstract**

A solar inverter is described comprising a DC input for connection to photovoltaic devices, an AC output for connection to an AC grid, a first enclosed zone and a second, partially enclosed zone. The solar inverter comprises a capacitor bank having one or more capacitors for maintaining a DC link voltage, a converter for converting the DC link voltage into an AC voltage and a coil box that is connected between the converter and the AC output. The coil box includes one or more inductors, is mounted within the second zone, has connections to the converter that are accessible to the first zone and is otherwise separated from an external casing of the first zone by an air gap.

## Description

### FIELD OF THE I NVENTI ON

The present invention relates to solar inverters.

### BACKGROUND OF THE INVENTION

Solar inverters are well known apparatus intended to convert energy obtained from sunlight by the use of photovoltaic cells into electrical energy for use locally or for transmission to remote consumers using an electrical transmission network (electricity grid). The standard elements of a solar inverter are: a DC (input) module, a converter module and an AC (output) module. The DC module is connected to a number of photovoltaic cells that provide a direct current (DC) input to the inverter. The converter module uses a number of electronic switches, typically insulated gate bipolar transistors (IGBTs), to convert the DC input into an alternating current (AC) output. For inverters providing electric power to an electrical transmission network, the AC module provides the AC output in a format suitable for the electricity grid.

It is desired to provide solar inverters that are small and light. A small solar inverter facilitates flexibility in installation since it may be mounted in positions where larger equipment would be impractical. A light solar inverter, particularly one which does not require substantial equipment such as a crane to install has a much lower installation cost. A problem with providing small, light solar inverters is that a number of elements of a typical solar inverter generate significant amounts of heat. Placing elements of a solar inverter close to another element that is generating heat can impair performance. Accordingly, handling heat is an important aspect in enabling the provision of small, light solar inverters.

It may be seen as an object of embodiments of the present invention to provide a solar inverter which is lighter in relation to its power conversion capability than prior art solar inverters.

It may be seen as a further object of embodiments of the present invention to provide a solar inverter which is smaller in relation to its power conversion capability the prior art solar inverters.

### SUMMARY OF THE I NVENTI ON

The above-mentioned objects are complied with by providing, in a first aspect, a solar inverter comprising a DC input suitable for connection to one or more photovoltaic devices, an AC output suitable for connection to an AC grid, a first enclosed zone and a second, partially enclosed, zone, the solar inverter further comprising:
- a converter for converting a DC link voltage into an AC voltage; and
- a coil box that is connected between the converter and the AC output, wherein the coil box includes one or more inductors, is mounted within the second zone, has connections to the converter that are accessible to the first zone and is otherwise separated from an external casing of the first zone by an air gap.

The provision of the coil box within the second (partially enclosed) zone prevents most of the heat generated by the coil box from affecting components within the first zone (such as the capacitor bank and the converter, both of which can have a performance that is affected by temperature). Further, the provision of an air gap between the coil box and the external casing of the first zone significantly reduces the transfer of heat from the coil box to the first zone due to the poor thermal conductivity of air. Moreover, heat from the coil box can be more easily removed from the second (partially enclosed) zone that the first

(enclosed) zone. Thus, keeping heat from the coil box out of the first zone makes it easier to cool the solar inverter. As a result, a lighter and m ore com pact inverter can be provided.

The solar inverter may further comprise a capacitor bank comprising one or more capacitors for maintaining the DC link voltage wherein the capacitor bank and/or the converter is/are provided within the first zone.

In a preferred embodiment the connections from the coil box to the converter that are accessible to the first zone are provided such that a path from the coil box to the first zone has poor thermal conductivity. This may be achieved by providing, for example, plastic thermal insulation.

The solar inverter may further comprise a DC stage connected between the DC input and the capacitor bank and an AC stage connected between the coil box and the AC output. The DC stage might include a DC filter. Alternatively, or additionally, the DC stage may include switches and/or contactors. Similarly, the AC stage might include an AC filter. Alternatively, or additionally, the AC stage may include switches and/or contactors.

The first enclosed zone may comprise a front section and a rear section, wherein the rear section is adjacent to the second, partially enclosed zone of the solar inverter. Furthermore, the DC stage and the AC stage may be provided in said front section, and the capacitor bank and the converter may be provided in said rear section. Providing both a front and a rear section within the first enclosed zone enables the cross-sectional area of the solar inverter to be reduced. Thus, it is possible to provide a smaller and lighter solar inverter. Furthermore, the separation of elements of the solar inverter into different zones makes it possible to protect zones by different casing, which can, in some embodiments, be used to reduce the impact of electromagnetic interference. The separate zones may, for examples, be separated using metal casings.
Some of the elements mounted within the first zone may be provided with cooling fins extending into the second zone.

In some embodiments of the invention, a fan for circulating cooling air within the second zone is provided. I n this way, heat generated by the coil box can be largely routed away from the inverter via the airflow with the second zone. As a result, the thickness of the inverter housing can be significantly reduced, such that a lighter and more compact inverter can be provided.

The invention may include a control module. The control module may, for example control the converter. The control module may control switches/contactors of the AC and/or DC stages. The control module may be mounted within the rear section of the solar inverter.

The solar inverter may include an internal fan and an internal heat sink mounted within the first zone and an external heat sink (mounted within the second zone), wherein the internal fan is configured to cause air within the first zone to pass through the internal heat sink and the internal and external heat sinks are configured such that heat from the first zone is transferred away from the first zone (i.e. to the second zone). Any cooling air flow within the second zone will therefore further aid the transfer of heat away from the first zone.

I n a second aspect the present invention relates to a solar inverter comprising a first enclosed zone having a front section and a rear section, the solar inverter further comprising:
- a DC input suitable for connection to one or more photovoltaic devices;
- an AC output suitable for connection to an AC grid;
- a capacitor bank comprising one or more capacitors for maintaining a DC link voltage;
- a converter for converting the DC link voltage into an AC voltage;
- a DC stage connected between the DC input and the capacitor bank;
- an AC stage connected between the coil box and the AC output, and
- a coil box that is connected between the converter and the AC output, the coil box including one or more inductors,
wherein the DC stage and the AC stage are provided in the front section of the solar inverter, and the capacitor bank and the converter are provided in the rear section of the solar inverter.

Providing both a front and a rear section within the first enclosed zone enables the cross-sectional area of the solar inverter to be reduced. Thus, it is possible to provide a smaller and lighter solar inverter. Furthermore, the separation of elements of the solar inverter into different zones makes it possible to protect zones by different casing, which can, in some embodiments, be used to reduce the impact of electromagnetic interference. The separate zones may, for examples, be separated using metal casings.

The solar inverter may include a second, partially enclosed zone, wherein the rear section is adjacent to the second, partially enclosed zone of the solar inverter.

The coil box may be mounted within the second zone and may have connections to the converter that are accessible to the first zone. In many embodiments of the invention, the coil box is otherwise separated from an external casing of the first zone by an air gap. The provision of the coil box within the second (partially enclosed) zone significantly reduces the amount of heat generated by the coil box from affecting components within the first zone. The provision of an air gap between the coil box and the external casing of the first zone significantly reduces the transfer of heat from the coil box to the first zone due to the poor thermal conductivity of air. As discussed above, keeping heat from the coil box out of the first zone makes it easier to cool the solar inverter. As a result, a lighter and more compact inverter can be provided.

The solar inverter may further comprise a fan for circulating cooling air within the second zone.

The solar inverter may further comprise a control module. The control module may, for example control the converter. The control module may control switches/contactors of the AC and/or DC stages. The control module may be mounted within the rear section of the solar inverter.

The solar inverter may include an internal fan and an internal heat sink mounted within the first zone and an external heat sink (typically mounted within the second zone), wherein the internal fan is configured to cause air within the first zone to pass through the internal heat sink and the internal and external heat sinks are configured such that heat from the first zone is transferred away from the first zone (e.g. to the second zone). Any cooling air flow within the second zone will therefore further aid the transfer of heat away from the first zone.

### BRIEF DESCRI PTI ON OF THE DRAWINGS

The invention will now be described in further detail with reference to the following schematic drawings, in which:
Figure 1 shows a circuit schematic of a solar inverter in accordance with an aspect of the present invention;
Figure 2 shows an external view of a solar inverter in accordance with an aspect of the present invention;
Figure 3 shows a view of the bottom of the solar inverter of Figure 2;
Figure 4 shows a view of the rear of the solar inverter of Figure 2;
Figure 5 is a highly schematic cross-section of a solar inverter in accordance with an aspect of the present invention;
Figure 6 shows a detail of the solar inverter of Figure 5;
Figure 7 is a highly schematic cross-section of a further embodiment, similar to that shown in Figures 5 and 6;
Figure 8 is highly schematic cross-section of a solar inverter in accordance with a further aspect of the present invention; and
Figure 9 is highly schematic cross-section of a modified version of the solar inverter of Figure 8.

### D ETAI LED D ESCRI PTI ON OF THE I NVENTI ON

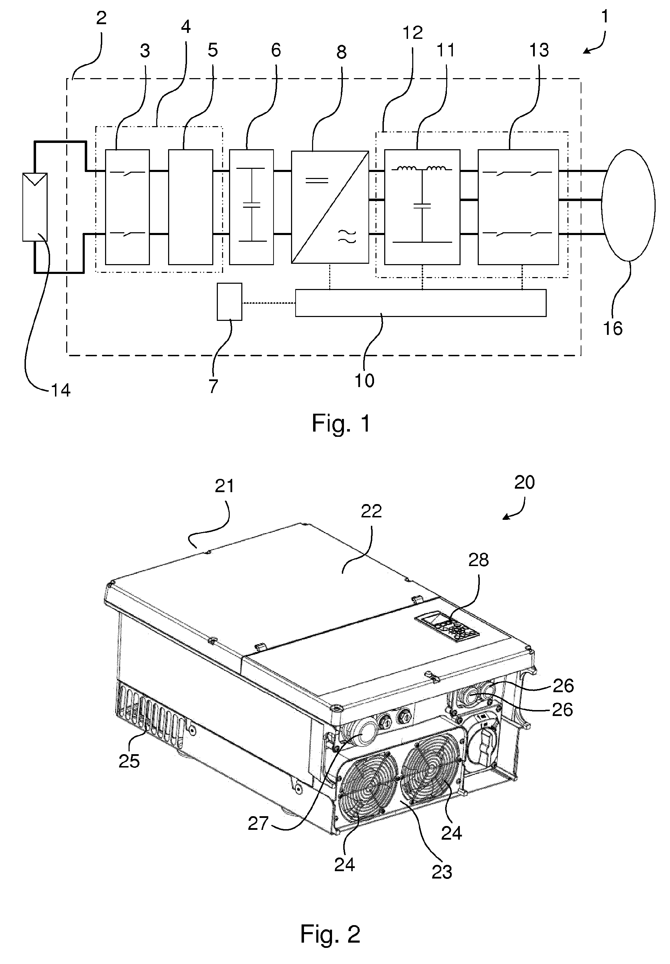

Figure 1 shows a circuit schematic, indicated generally by the reference numeral 1, of a solar inverter in accordance with an aspect of the present invention. One or more photovoltaic strings 14 are connected to a DC input stage 4, which in this embodiment comprises a DC switch 3 followed by a DC filter 5. A capacitor bank 6 smooths the DC at this stage before feeding it into the DC input of a converter 8 which converts the DC bus voltage into an alternating voltage. In this embodiment, the converter 8 is a three-phase converter producing three-phase AC. It is also possible to use a single-phase converter, or a converter that outputs more phases than three. An AC output stage 12 follows the converter 8. The AC output stage 12 comprises an AC filter 11 and an output contactor 13. The three-phase AC output is fed into a distribution grid 16. The operation of the solar inverter 1 is controlled by a controller 10, and a control panel 7 allows an operator to access this controller for installation or maintenance. It is also possible to control the solar inverter 1 via other means of communications such as data networks or wireless channels (not shown). The equipment forming the solar inverter 1 can be conveniently housed and housing 2 which can be made weatherproof to a standard appropriate for the environment in which the solar inverter 1 is used.

Figure 2 shows an external view of a solar inverter, indicated generally by the reference numeral 20, in accordance with an embodiment of the present invention. The top of the solar inverter is shown by the reference numeral 21, and the front by the reference numeral 22. Since the solar inverter will often be used outside, it is housed in a weatherproof casing. I n the view illustrated in Figure 2, the bottom face of the solar inverter housing is visible. This comprises an air inlet 23, here supplied with two external fans 24. Air circulates from the air inlet to an air outlet 25 near the top of the housing. Cable glands are also illustrated; for DC input cables 26 from photovoltaic panels, and for an AC output cable 27. A control panel 28 is also shown in the front panel 22. The control panel allows interaction between an operator and the solar inverter for the purposes of, for example, installation or maintenance.

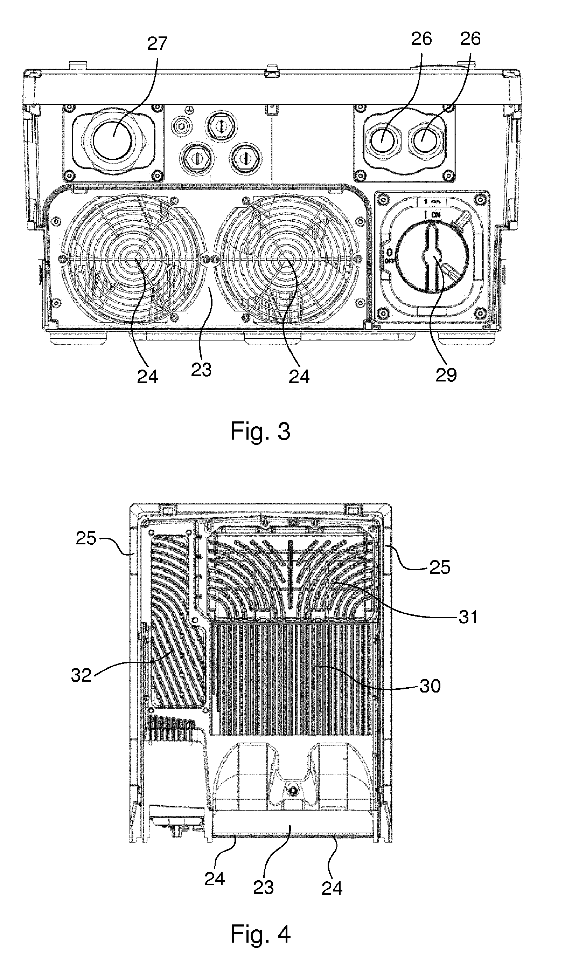

Figure 3 shows a view of the bottom of the solar inverter 20 of Figure 2 where the same features as identified above are shown. In this figure a DC switch 29 is also clearly shown for isolating the DC input.

Figure 4 shows a view of the rear of the solar inverter 20 of Figure 2. A rear cover, which would normally be in place when the solar is inverter is in use, is not shown here. In this view, the fins of several heatsinks are visible. These include the heatsink 30 connected to a converter, the heatsink 31 connected to a coil box and the heatsink 32 connected to a capacitor bank. The fins of these heatsinks are angled to assist the flow of air from the air inlet 23 to the air outlets 25.

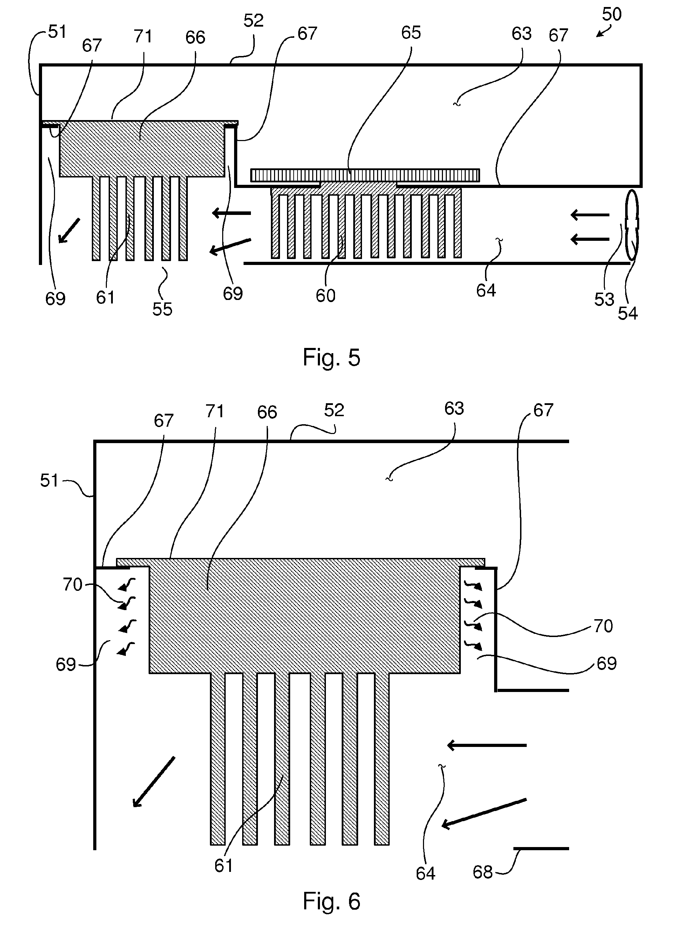

Figure 5 is a highly schematic cross-section of a solar inverter, indicated generally by the reference numeral 50, in accordance with an aspect of the present invention. Here the top 51 of the solar inverter is to the left, and the bottom to the right. The front 52 is illustrated at the top of Figure 5. The solar inverter 50 is divided into a first enclosed zone 63, which is essentially sealed from the outside environment, and a second, partially enclosed, zone 64, which has openings to the outside environment. One opening, illustrated here, is an air inlet 53, here shown with a fan 54 to introduce air from the outside environment into the partially enclosed zone 64. Another opening shown is an air exit 55 where air is returned to the outside environment. The circulation of air enhances the extraction of heat from inside the solar inverter 50 and delivery to the outside environment. The division of the solar inverter 50 into a first enclosed zone 63 and a second partially enclosed zone 64 is made by means of a dividing wall 67 which is essentially continuous, although some interruptions in this wall are necessary for the conduction of heat or for the passage of signal and/or power cables from one zone to another. These interruptions are minor in extent, and designed so that there is little air movement from one zone to the other. In Figure 5 are illustrated two heat generating components which form part of the solar inverter 50. The first heat generating component is a converter unit 65 for converting the DC link voltage into an AC voltage. This is attached firmly to a heatsink 60, the fins of which extend into the partially enclosed zone 64. Heat generated in the converter 65 is conducted into the heatsink 60 and thereby into the airflow which is present in the partially enclosed zone 64. The second heat generating component is a coil box 66. This coil box contains inductors used in filtering and generates heat when in service. The housing of the coil box comprises a heatsink 61 which also extends into the partially enclosed zone 64, enabling heat generated within the coil box to be passed onto the airflow which is present in the partially enclosed zone 64.

Figure 6 shows a detail of the solar inverter 50 shown in Figure 5. Here we see again the coil box 66 with its corresponding heatsink 61. The dividing wall 67 is also shown. It is to be noted that although the bulk of the coil box physically lies within the partially enclosed zone 64, the dividing wall 67 exhibits an extension into the part of the housing which is otherwise utilised by the enclosed zone 63. That is to say, the area of the dividing wall 67 at which the coil box 66 is mounted deviates from the normal level of the dividing wall 67 into the enclosed zone 63. The heat generated by the coil box requires that a certain minimum size of heatsink 61 is utilised and that it be positioned within the airflow of the partially enclosed zone 64. Since the thickness of the partially enclosed zone 64 measured from the rear wall 68 to the dividing wall 67 is very restricted, there is insufficient space to fit both the main bulk of the coil box 66 and the heatsink 61 within the undeviated thickness of the partially enclosed zone 64. The local deviation of the partially enclosed zone 64 into the enclosed zone 63 enables the bulk of the coil box 66 to be mounted away from the restricted space of the enclosed zone 63. In the prior art inverters this problem is normally solved by mounting the coil box within the enclosed zone 63, and allowing only the heatsink 61 to extend into the partially enclosed zone 64. This prior art solution has the disadvantage in that the hot coil box radiates heat directly into the enclosed zone 63. The forming of the dividing wall 67 in the manner shown in Figure 6 allows an air gap 69 to be left between the wall of the coil box and the dividing wall 67. Such an air gap is extremely effective in preventing radiation from the coil box 66 entering the enclosed zone 63. The arrows 70 graphically show the radiation of heat from the hot coil box 66. In prior art devices this radiation would directly enter the enclosed zone 64 and be responsible for heating up any circuits or equipment within that zone. The formation illustrated in Figure 6 prevents this happening and allows the heat generated by the hot coil box 66 to be routed almost entirely to the heatsink 61 and thus to the airflow in the partially enclosed zone 64. Thus the embodiment shown in Figures 5 and 6 allows the thickness of the inverter housing to be significantly reduced, leading to a lighter and more compact inverter than prior art inverters. The coil box 66 of the embodiment shown in Figures 5 and 6 is mounted on the dividing wall 67 at the end furthest from the heatsink 61. Heat may leave the coil box 66 by several means; by conduction to the heatsink 61, by conduction through the mounting points on the dividing wall 67, by radiation from the sides 70 and by radiation from the face 70 within the enclosed zone 64. Conduction through the mounting points is limited, since there is only a minimal contact point between the coil box 66 and the dividing wall 67. Radiation from the sides 70 has to pass through the air gap 69 and even then is retained within the partially enclosed zone 64. Radiation from the face 71 will be absorbed within the enclosed zone 64.

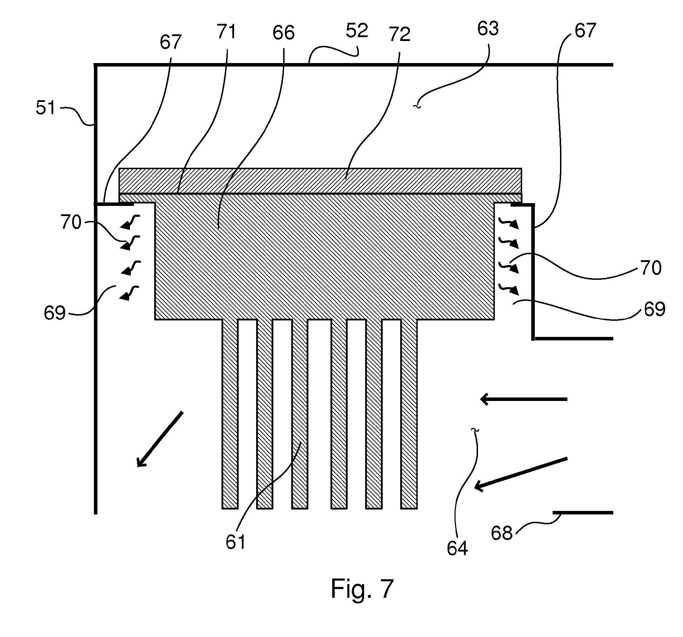

Figure 7 is a highly schematic cross-section of a further embodiment, similar to that shown in Figures 5 and 6. In this embodiment, the coil box 66 is constructed with a thermally insulating layer 72, mounted on the face 71, and which reduces significantly radiation from the face 71. The thermally insulating layer 72 may comprise a plastic insulating layer of, for example, foam plastic or expanded polystyrene.

The embodiments shown in Figures 5, 6 and 7 exhibit connections from the coil box 66 to the converter which lies within the enclosed zone 63 which have poor thermal conductivity.

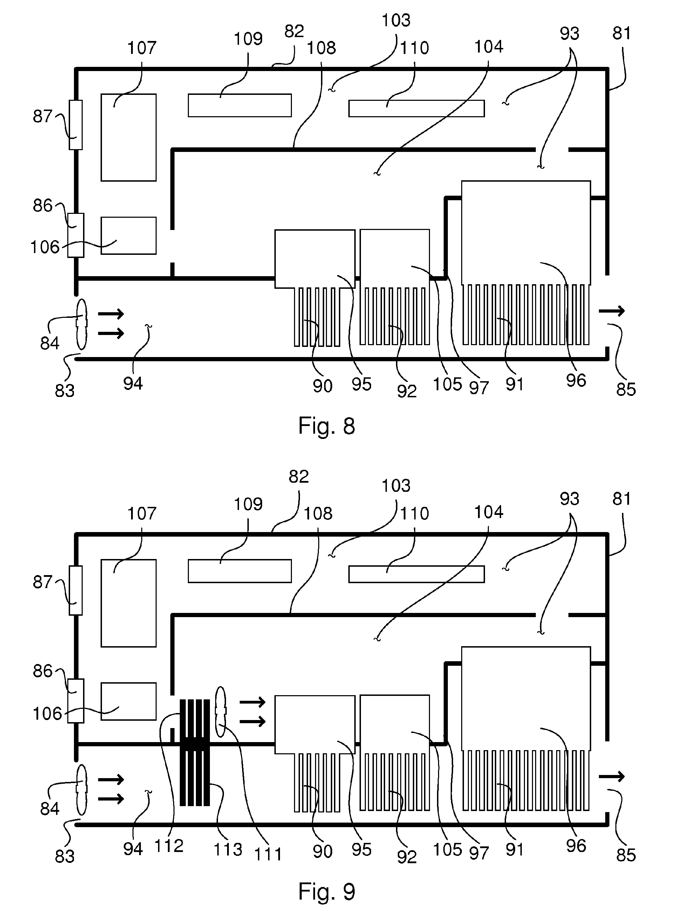

Figure 8 is highly schematic cross-section of a solar inverter, indicated generally by reference numeral 80, in accordance with an aspect of the present invention. I n Figure 8 the front of the solar inverter is denoted by the reference numeral 82 and the top of the solar inverter by the reference numeral 81. This embodiment comprises a first enclosed zone 93 having a front section 103 and a rear section 104 separated by a wall 108. Also shown is a DC input connector area 86, suitable for connection to one or more photovoltaic devices, a DC input stage 106, an AC output connector area 87, suitable for connection to an AC grid, an AC output stage 107, a capacitor bank 105 comprising one or more capacitors for maintaining a DC link voltage, a converter 95 for converting the DC link voltage into an AC voltage and a coil box 96 which includes one or more inductors. In this embodiment the division of the enclosed zone 93 into the front section 103 and the rear section 104 allows the separation of individual electrical or electronic apparatus so that, for example, electrical noise or the distribution of heat can be controlled. In the front section 103 electrical or electronic apparatus such as a power supply 109 or a communications board 110 are housed. Also shown in Figure 8 is a second, partially enclosed, zone 94 at the rear of the solar inverter 80. A dividing wall 97 separates the enclosed zone 93 from the partially enclosed zone 94. In the partially enclosed zone 94 air is circulated from an inlet 83 to an outlet 85, and may be assisted by a fan 84. The converter 95, capacitor bank 105 and the coil box 96 each have a connected heatsink (90, 92 and 91 respectively) which protrudes into the circulating air within the partially enclosed zone 94. In this way heat generated is moved to the rear of the device and exits through the airflow. The dividing of the solar inverter housing into three or more zones, particularly the layering of the zones from the rear to the front of the housing as illustrated here, enables a very compact solar inverter to be constructed. Such a compact construction is, as discussed above, extremely advantageous.

Figure 9 is highly schematic cross-section of a solar inverter, which is generally identical to that shown in Figure 8 and the same reference numerals are hereby used. The embodiment illustrated in Figure 9 shows an additional fan 111 which circulates air around the enclosed zone 93. When in operation, the fan 111 draws air through a heatsink 112 which is thermally connected to a portion of the dividing wall 97. Another heatsink 113 is positioned on the opposite side of the dividing wall 97 and protrudes into the partially enclosed zone 94. In this manner, the circulating air in the enclosed zone 93 which takes up heat from the various pieces of equipment in that zone is cooled by passing through the heatsink 112. The heatsink 112 is in turn cooled by being thermally connected to the heatsink 113 which is directly in the output stream of fan 84, and is thus cooled by air drawn from the outside environment. This method is an extremely compact solution to the problem of removing heat generated within the enclosed zone 93 but avoids the circulation of outside air (which may have an unacceptably high dust or water content) directly within the enclosed zone 93. The use of fans may, under certain circumstances where the amount of heat generated is lower, be optional. In these cases the equipment may be constructed so that their circulation is driven by convection of warmed air. The use of heatsinks may, under certain circumstances where the amount of heat generated is lower, be optional. For example, it may be that the air blast from the external fan 84 impinging on a particular area of the dividing wall 97 provide sufficient cooling to the internal heatsink 112, without a specially constructed heatsink 113.

The embodiments of the invention described above are provided by way of example only. The skilled person will be aware of many modifications, changes and substitutions that could be made without departing from the scope of the present invention. The claims of the present invention are intended to cover all such modifications, changes and substitutions as fall within the spirit and scope of the invention.

## Claims

1. . A solar inverter comprising a DC input suitable for connection to one or more photovoltaic devices, an AC output suitable for connection to an AC grid, a first enclosed zone and a second, partially enclosed, zone, the solar inverter further comprising:
a converter for converting a DC link voltage into an AC voltage; and
a coil box that is connected between the converter and the AC output, wherein the coil box includes one or more inductors, is mounted within the second zone, has connections to the converter that are accessible to the first zone and is otherwise separated from an external casing of the first zone by an air gap.

2. . A solar inverter as claimed in claim 1, further comprising a capacitor bank comprising one or more capacitors for maintaining the DC link voltage wherein the capacitor bank and/or the converter is/are provided within the first zone.

3. . A solar inverter as claimed in claim 1 or claim 2, wherein the connections from the coil box to the converter that are accessible to the first zone are provided such that a path from the coil box to the first zone has poor thermal conductivity.

4. . A solar inverter as claimed in claim 3, wherein the poor thermal conductivity is ensured by providing plastic insulation.

5. . A solar inverter as claimed in any preceding claim, further comprising a DC stage connected between the DC input and the capacitor bank and an AC stage connected between the coil box and the AC output.

6. . A solar inverter as claimed in any preceding claim, wherein the first enclosed zone comprises a front section and a rear section, wherein the rear section is adjacent to the second, partially enclosed zone of the solar inverter.

7. . A solar inverter as claimed in claim 6, when dependent on claim 5, wherein the DC stage and the AC stage are provided in said front section, and the capacitor bank and the converter are provided in said rear section.

8. . A solar inverter as claimed in any preceding claim, wherein at least some of the elements mounted within the first zone are provided with cooling fins extending into the second zone.

9. . A solar inverter comprising a first enclosed zone having a front section and a rear section, the solar inverter further comprising:
a DC input suitable for connection to one or more photovoltaic devices;
an AC output suitable for connection to an AC grid;
a capacitor bank comprising one or more capacitors for maintaining a DC link voltage;
a converter for converting the DC link voltage into an AC voltage;
a DC stage connected between the DC input and the capacitor bank;
an AC stage connected between the coil box and the AC output; and
a coil box that is connected between the converter and the AC output, the coil box including one or more inductors,
wherein the DC stage and the AC stage are provided in the front section of the solar inverter, and the capacitor bank and the converter are provided in the rear section of the solar inverter.

10. . A solar inverter as claimed in claim 9, further comprising a second, partially enclosed zone, wherein the rear section is adjacent to the second, partially enclosed zone of the solar inverter.

11. . A solar inverter as claimed in claim 10, wherein the coil box is mounted within the second zone and has connections to the converter that are accessible to the first zone.

12. . A solar inverter as claimed in any preceding claim, further comprising a fan for circulating cooling air within the second zone.

13. . A solar inverter as claimed in any preceding claim, further comprising a control module.

14. . A solar inverter as claimed in any preceding claim, further comprising an internal fan and an internal heat sink mounted within the first zone and an external heat sink, wherein the internal fan is configured to cause air within the first zone to pass through the internal heat sink and the internal and external heat sinks are configured such that heat from the first zone is transferred out of the first zone.
